# EUROPEAN PATENT SPECIFICATION

(11) **EP 2 505 686 B1**
(45) Date of publication and mention of the grant of the patent: **09.09.2020**
(21) Application number: 12162480.3
(22) Date of filing: 30.03.2012
(51) Int. Cl.: C22C 9/00, C22C 1/04, C23C 14/34, H01J 37/34

(54) **CU-GA-BASED ALLOY POWDER WITH LOW OXYGEN CONTENT, CU-GA-BASED ALLOY TARGET MATERIAL AND METHOD FOR PRODUCING THE TARGET MATERIAL**
CU-GA-BASIERTES LEGIERUNGSPULVER MIT NIEDRIGEM SAUERSTOFFGEHALT, CU-GA-BASIERTES LEGIERUNGSPULVER-ZIELMATERIAL UND VERFAHREN ZUR HERSTELLUNG DES ZIELMATERIALS
POUDRE D'ALLIAGE À BASE DE CU-GA AVEC UN CONTENU À FAIBLE TENEUR EN OXYGÈNE, MATÉRIAU CIBLE D'ALLIAGE À BASE DE CU-GA ET PROCÉDÉ DE PRODUCTION DU MATÉRIAU CIBLE

(30) Priority: 01.04.2011 JP 2011081806
(43) Date of publication of application: 03.10.2012
(73) Proprietor: SANYO SPECIAL STEEL CO., LTD., Himeji-shi Hyogo-ken (JP)
(72) Inventor: Sawada, Toshiyuki, Hyogo-ken (JP)
(74) Representative: Hoffmann Eitle

(56) References cited:
- WO-A1-2010/119887
- JP-A- 2000 073 163
- JP-A- 2008 138 232
- US-A1- 2010 116 341

## Description

### TECHNICAL FIELD

The present invention relates to a low oxygen Cu-Ga based alloy powder for producing a light absorbing layer in a solar cell and a method for producing a sputtering target material.

### BACKGROUND ART

Cu-Ga based target materials are conventionally used as sputtering targets for producing light absorbing layers in solar cells. For example, JP2000-73163A (Patent Literature 1) discloses a Cu-Ga based target material of which the oxygen content is lowered to 200 ppm or less by conducting casting according to melting method with the Ga content being 15 to 70 wt%. It is described that sputtering using this target material makes it possible to produce a high-grade thin film having a precise composition for a light absorbing layer in a solar cell, without generating an abnormal electrical discharge, particles and a splash during film formation and without causing contamination by oxide. In this way, Cu-Ga based target materials are often produced through casting method.

However, in the case of the casting method according to melting method disclosed in Patent Literature 1, a high Ga-content Cu-Ga binary alloy target that is prepared through melting and casting becomes more hard and brittle as it contains more Ga. In particular, there is a problem that a high Ga-content Cu-Ga binary alloy target containing Ga in an amount of 30 mass% or more tends to generate cracks or defects at the time of cutting the surfaces to prepare final products, and thus provides more defective products, resulting in a poor yield.

Thus, instead of the casting method according to melting method disclosed in Patent Literature 1, there are disclosed techniques using powder metallurgy method, for example, in JP2008-138232A (Patent Literature 2) and JP2010-265544A (Patent Literature 3). These techniques using powder metallurgy method are used particularly for the production of targets containing high concentrations of Ga, since there can be obtained a fine microstructure and a high strength, compared to casting method as in Patent Literature 1 in which the target becomes more hard and brittle with an increasing Ga concentration to generate cracks or defects during machining.

However, the above target materials obtained through powder metallurgy method have a problem that oxygen content generally becomes higher than those obtained through casting method. For example, the oxygen content of the Cu-Ga based target material prepared through vacuum melting and casting method described in Example 1 of Patent Literature 1 is 25 ppm, while the oxygen content of the Cu-Ga based target material prepared through powder metallurgy method disclosed in the Examples of Patent Literature 3 is as high as 250 to 310 ppm.

On the other hand, Patent Literature 2 discloses that a raw material powder comprising the mixture of a low Ga-content powder and a high Ga-content powder is consolidated, but the solidus line (melting initiation temperature) in Cu-Ga based alloy drops sharply with an increasing Ga content as seen from the binary phase diagram. Thus, there is a problem that it becomes necessary to adopt a significantly low consolidation temperature in order to avoid melting during consolidation.

Accordingly, consolidation at a high temperature is problematic for consolidating a raw material powder using the mixture of a low Ga-content powder and a high Ga-content powder. In addition, in Patent Literature 2, no elucidation has been made on a low oxygen-content Cu-Ga based alloy powder.

Further relevant prior art is disclosed in Patent Literature 4 and 5.

### CITATION LIST

### [Patent Literature]

[Patent Literature 1] JP2000-73163A
[Patent Literature 2] JP2008-138232A
[Patent Literature 3] JP2010-265544A
[Patent Literature 4] WO 2010/119887 A1
[Patent Literature 5] US 2010/116341 A1

### SUMMARY OF INVENTION

As described above, Patent Literature 1 has the problem that casting method makes the product hard and brittle to cause cracks or defects during machining. The trend has thus been generally shifting toward target materials prepared through powder metallurgy. However, in the case of using a powder mixture prepared through powder metallurgy as disclosed in Patent Literature 2, consolidation is all conducted at a temperature as low as 200 °C as shown in the Examples thereof. At such a low consolidation temperature, the density of the target material may not be raised sufficiently, having a problem that a low density and a high oxygen content can be a cause for generating an abnormal electrical discharge or particles during sputtering as described in paragraph [0004] of Patent Literature 1.

In addition, a target material consisting of two or more phases also has a problem that irregularity generates on the surface of the target material at a later stage of sputtering due to difference in sputtering rate among the phases or the like and thus increases particles that lead to an increase in failure rate. Furthermore, Patent Literature 3 proposes a target material having an oxygen content as high as 250 to 310 ppm. However, such a high oxygen content of at least 250 ppm is not necessarily sufficient for forming a high-grade thin film having a precise composition for a light absorbing layer in a solar cell, without generating an abnormal electrical discharge, particles and a splash during sputtering and without causing contamination by oxide.

In order to improve the high oxygen content that has the problem with powder metallurgy as described above, the inventor made extensive research on oxygen content, crystal particle size and consolidation temperature in terms of the composition of raw material alloy powder and gas atomizing method and the like, and thus reached the present invention.

It is thus an object of the present invention is to provide a low oxygen Cu-Ga based sputtering target material for producing a light absorbing layer in solar cell and a powder therefor.

According to the present invention, there is provided a Cu-Ga based alloy powder consisting of, in at%, not less than 25% and less than 40 % of Ga, the balance being Cu and unavoidable impurities, wherein the powder has an oxygen content of 200 ppm or less.

According to another aspect of the present invention, there is provided a Cu-Ga based alloy sputtering target material consisting of, in at%, not less than 25% and less than 40 % of Ga, the balance being Cu and unavoidable impurities, wherein the sputtering target has an oxygen content of less than 250 ppm and a crystal particle size of more than 10 µm and not more than 100 µm.

According to another aspect of the present invention, there is provided a method for producing a Cu-Ga based alloy sputtering target material comprising:
providing, as a raw material, the above Cu-Ga based alloy powder; and
consolidating the raw material at a temperature of 400 to 850 °C.

### DESCRIPTION OF EMBODIMENTS

The present invention is explained in detail below. It is noted that "%" indicates herein "at%" unless otherwise defined.

The Cu-Ga based alloy powder according to the present invention consists of, in at%, not less than 25% and less than 40 % of Ga, the balance being Cu and unavoidable impurities, preferably consisting essentially of these elements and unavoidable impurities, more preferably consisting of these elements and unavoidable impurities. This powder may contain oxygen as unavoidable impurities, while the oxygen content is as extremely low as 200 ppm or less. The Cu-Ga based alloy sputtering target material obtainable by using this Cu-Ga based alloy powder consists of, in at%, not less than 25% and less than 40 % of Ga, the balance being Cu and unavoidable impurities, and has an oxygen content of less than 250 ppm and a crystal particle size of more than 10 µm and not more than 100 µm.

That is, it is the most important in the present invention that a Cu-Ga based alloy sputtering target material and a Cu-Ga based alloy powder to be used as a raw material therefor, which have low oxygen contents, can be obtained by controlling Ga content and crystal particle size and adopting high consolidation temperature. It has been found that preparing a powder from a Cu-Ga alloy within the range of Ga content in the present invention by a production method such as gas atomizing method results in an oxygen content which is lower than that of a Cu-Ga based alloy having a Ga content of less than 25% or not less than 40%.

Although detailed reasons for this phenomenon are uncertain, in the binary phase diagram of Cu-Ga based alloy, the phase that mainly forms in the Ga content range of the present invention is Cu₉Ga₄ phase, of which low affinity with oxygen is considered to have some influence on the above phenomenon. It has further been found that consolidating this powder at a high temperature of 400 °C or higher makes it possible to suppress an increase in oxygen during consolidation.

In general, when heated to a high temperature, metal powder tends to react with oxygen slightly remaining in its periphery, even in the vacuum, to cause an increase in oxygen content. It has, however, been found that in the alloy of the present invention, consolidation at a low temperature of less than 400 °C leads to a particularly large increase in oxygen content while consolidation at a high temperature of 400 °C or higher can suppress the increase in oxygen content to a low level. Although detailed reasons for this phenomenon are uncertain, it is considered that Cu₉Ga₄ phase, which is the main phase of the alloy of the present invention, has a low affinity with oxygen and that when heated to a high temperature of 400 °C or higher, the equilibrium value for containing oxygen becomes lower than that at a low temperature of less than 400 °C. Using as the raw material a single alloy powder as described above enables consolidation at a higher temperature. In addition, the Cu-Ga based target material of the present invention has a crystal particle size of more than 10 µm and not more than 100 µm, which are relatively larger than those of Patent Literature 3.

While it is generally believed that, in the alloy of the present invention, finer crystal particles lead to a higher strength, the target material according to the present invention has a relatively coarse crystal particle size as mentioned above. However, it has been found that this target material has a strength which is sufficiently durable for practical use. The reason for this is thought to be that the target material of the present invention has a low oxygen content, which leads to a small amount of oxides in the particle boundary to provide an superior strength, even if the crystal particle size is relatively coarse. In particular, it has been found that an oxygen content of less than 250 ppm brings a high strength. Although the crystal particle sizes of atomized powders are sufficiently smaller than those of the present invention, the crystal particle size becomes large as the consolidation temperature is raised. Therefore, consolidation at a temperature of 400 to 850 °C makes it possible to obtain a consolidated compact having particle sizes in the range of the present invention.

The inventor has also studied gas atomizing or disc atomizing and found that, in the alloy composition of the present invention, the use of N₂ gas as a gas for replacing the inside of the tank or blowing into the molten metal is easier to achieve a low oxygen content than Ar gas.

The alloy powder of the present invention comprises Ga in an amount of not less than 25% and less than 40 %, preferably more than 29% and not more than 38%, more preferably not less than 30% and not more than 35%. These ranges enable achievement of a Cu-Ga based alloy powder having a low oxygen content of 200 ppm or less. Ga content of less than 25% or not less than 40 % results in an increase in oxygen content. As mentioned above, the reason for this is that, in the binary phase diagram of Cu-Ga based alloy, the phase that mainly forms in the above Ga content ranges is Cu₉Ga₄ phase, of which low affinity with oxygen is considered to have influence. In particular, this tendency is remarkable in manufacturing methods such as gas atomizing method.

The alloy powder of the present invention has an oxygen content of less than 200 ppm, preferably 150 ppm or less, more preferably 100 ppm or less. The use of a powder of the alloy of the present invention having an oxygen content of less than 200 ppm makes it possible to obtain a consolidated compact having an oxygen content of less than 250 ppm.

The alloy powder of the present invention is preferably prepared through an atomizing method other than water atomizing method, as represented by gas atomizing method or disc atomizing method. This is because methods such as pulverizing method, in which a cast material obtained through vacuum melting method or the like or a ribbon obtained through quenched ribbon method as a raw material is pulverized, or water atomizing method result in a high oxygen content. The gas for replacing the inside of the tank or blowing into the molten metal may be Ar, N₂ or the like, N₂ being preferable for achieving a further lower oxygen content when used.

The sputtering target material of the present invention has an oxygen content of less than 250 ppm, preferably not more than 200 ppm, more preferably not more than 180 ppm. Oxygen content of less than 250 ppm makes it possible to produce a high-grade thin film having a precise composition for a light absorbing layer in a solar cell, without generating an abnormal electrical discharge, particles and a splash during sputtering and without causing contamination by oxide. The oxygen content of this range also brings a high strength at the same time.

The sputtering target material of the present invention has a crystal particle size of more than 10 µm and not more than 100 µm, preferably from 20 to 100 µm. Crystal particle size of 10 µm or less fails to achieve a sufficiently high consolidation temperature and also fails to attain an effect of suppressing an increase in the oxygen content during consolidation. Crystal particle size of 100 µm or more results in a low strength of the consolidated compact.

The sputtering target material of the present invention is obtained by consolidating the Cu-Ga based alloy powder as the raw material at a temperature of 400 to 850 °C. At this time, it is preferable that a substantially single alloy powder be used. That is, in the case of producing target materials of the same Ga content through powder metallurgy method, a single alloy is preferable in that the single alloy enables consolidation at a higher temperature than the mixture of a low Ga-content powder and a high Ga-content powder. The reason for this is that, as mentioned above, the solidus line (melting initiation temperature) in Cu-Ga based alloy drops sharply with an increasing Ga content as seen from the binary phase diagram of Cu-Ga based alloy. This necessitates a low consolidation temperature in order to avoid melting during consolidation, making it impossible to set a high consolidation temperature even if consolidation at a higher temperature is desired. It should be noted that, in the present invention, using a substantially single alloy powder allows inevitable variation of the Ga content depending on lots of atomizing even in the alloy powder of the equivalent Ga content. In this way, the mixture of different lots of the equivalent Ga content is to be regarded as the substantially single alloy powder.

The consolidation temperature in the production method of the present invention is from 400 to 850 °C, preferably from 650 °C to 830 °C, more preferably from 700 °C to 800 °C. For the sputtering target material of the present invention, consolidation at a high temperature can suppress the increase in oxygen during the consolidation. Consolidation temperature of lower than 400 °C results in a large increase in oxygen, while consolidation temperature of higher than 850 °C results in melting. In terms of yield, consolidation by hot pressing is preferred. In addition, since there is a trend that sputtering target materials in the use of the present invention become larger, it is preferable that the consolidation pressure be 10 MPa or more and that the consolidation time be 0.5 hour or more, in order to stably obtain a consolidated compact having a sufficient density. On the other hand, in terms of reducing as much as possible the increase in oxygen amount during consolidation from the powder, hot isostatic pressing method (HIP method) is preferred. In this case, it is preferable that the consolidation pressure be 50 MPa or more and that the consolidation time be 2 hours or more.

### EXAMPLES

The present invention is explained in detail below with reference to examples.

20 kg of molten raw material which was weighed to have the composition shown in Table 1 was melted in a refractory crucible to tap this molten material through a nozzle having an inner diameter of 8 mm, and was then atomized with the gas shown in Table 1. The obtained powder was screened through a sieve having an opening size of 500 µm to provide a powder having particle diameters of 500 µm or less, on which oxygen analysis was conducted. The alloy powders thus prepared were mixed in the combinations shown in Table 2 so as to bring the total compositions shown in Table 2, providing raw material powders. In Table 2, the samples for which one type of alloy powder is mentioned are those using a single alloy powder as the raw material powder without being mixed with other powder. In addition, the parenthesis that follows the composition indicates atomizing gas.

These raw material powders were consolidated under the conditions shown in Table 2 to form consolidated compacts, from which specimens were cut out, followed by analysis on oxygen content. In hot pressing method, a graphite mold having a diameter of 105 mm was used to perform consolidation in vacuum to provide a height of about 10 mm. In HIP method, a vessel made of carbon steel having a diameter of 150 mm and a height of 100 mm was used and then filled with the powder, followed by degassing and charging to perform consolidation. In addition, in either process, specimens for oxygen analysis were prepared from the central parts of the consolidated compacts by wire cutting and plane polishing. Furthermore, for comparison, the raw material that was induction-melted in the refractory crucible in Ar atmosphere under a reduced pressure was cast in a casting mold having a diameter of 105 mm and a height of 100 mm to prepare a cast material as a comparative material.

The crystal particle sizes of the target materials were evaluated by performing mirror polishing on a specimen cut out from the prepared target material; eroding the polished surface with an acid solution to take an optical photomicrograph thereof; drawing a test straight line having a certain length on this photomicrograph; counting the number of the intersections between this line and the crystal particle boundaries; and calculating the ratio of the length of the test straight line to the number of the intersections, i.e., [Length of test straight line (µm)] / [Number of intersections (number)]. The transverse bending strengths of the target materials were evaluated by taking a specimen having a square of 2 mm and a length of 20 mm from the prepared target material and subjecting the specimen to a three-point transverse bending strength tester.

### [Table 1]

**Table 1**

| No. | Composition of alloy powder (at%) | | Atomizing method | Oxygen content (ppm) | Remarks |
|---|---|---|---|---|---|
| | Ga | Cu | Atomizing gas | | |
| 1 | 25 | balance | Ar | 150 | Present Invention Examples |
| 2 | 29 | balance | Ar | 130 | |
| 3 | 30 | balance | Ar | 110 | |
| 4 | 33 | balance | Ar | 100 | |
| 5 | 35 | balance | Ar | 120 | |
| 6 | 37 | balance | Ar | 150 | |
| 7 | 39 | balance | Ar | 180 | |
| 8 | 25 | balance | N₂ | 100 | |
| 9 | 33 | balance | N₂ | 60 | |
| 10 | 35 | balance | N₂ | 80 | |
| 11 | 24 | balance | Ar | 210 | Comparative Examples |
| 12 | 40 | balance | Ar | 230 | |

| | | | | | |
|---|---|---|---|---|---|
| Note 1) Underlined figures fall outside the conditions of the present invention. | | | | | |

Table 1 indicates the compositions of the alloy powders, the atomizing gasses and the oxygen contents in the powders.

As shown in Table 1, Nos. 1 to 10 are present invention examples while Nos. 11 and 12 are comparative examples. Comparative example No. 11 has a high oxygen content due to the low Ga content in the composition of the alloy powder. Comparative example No. 12 has a high oxygen content similarly to comparative example No. 11 due to the high Ga content in the composition of the alloy powder. In contrast, Nos. 1 to 10 all satisfy the conditions of the present invention, while in particular Nos. 8 to 10 indicated that the powders atomized with N₂ gas exhibited low oxygen analysis values of not more than 100 ppm

### [Table 2]

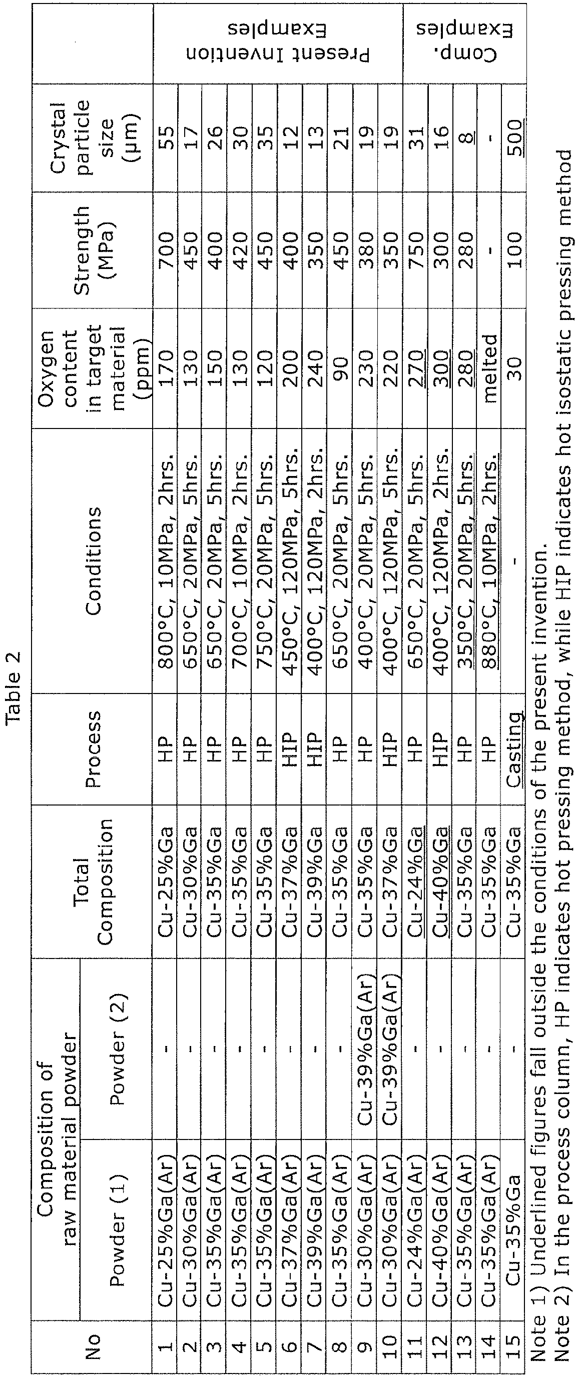

Table 2 shows the compositions of the raw material powders for the target materials, the total compositions thereof, the consolidation conditions (process, temperature, pressure and time) and the evaluation results thereof.

As shown in Table 2, Nos. 1 to 10 are present invention examples while Nos. 11 to 15 are comparative examples. Comparative example No. 11 has a high oxygen content due to the low Ga content in the composition of the raw material alloy powder. This generates an abnormal electrical discharge or particles during sputtering, causing contamination by oxide. Comparative example No. 12 has a high oxygen content due to the high Ga content in the composition of the alloy powder, and thus generates an abnormal electrical discharge or particles during sputtering, causing contamination by oxide.

Comparative example No. 13 has a high oxygen content in the sputtering target material and cannot be brought to a sufficiently high consolidation temperature due to the small crystal particle size, failing to attain a transverse bending strength, while the high oxygen content generates an abnormal electrical discharge or particles during sputtering, causing contamination by oxide. Comparative example No. 14 fails to attain a transverse bending strength and also has poor workability due to the high consolidation temperature. Comparative example No. 15 fails to attain a sufficient transverse bending strength and also has poor workability due to the large crystal particle size and due to casting instead of atomizing method.

In contrast, Nos. 1 to 10 are present invention examples all resulted in sputtering target materials satisfying the conditions of the present invention, each of which had a high transverse bending strength of 350 MPa or more and was workable to provide a sputtering target material having an outer diameter of 101.6 mm and a thickness of 5 mm through normal machining such as wire cutting or plane polishing.

In view of the above, according to the present invention, it is possible to provide a sputtering target material having a reduced oxygen content, enabling a suitable consolidation temperature, having a high transverse bending strength of 350 MPa or more, and a superior workability. Sputtering using this sputtering target material makes it possible to stably and efficiently form a Cu-Ca sputtered film having a film composition evenly, for example as a light absorbing layer in a solar cell.

## Claims

1. A Cu-Ga based alloy powder consisting of, in at%, not less than 25% and less than 40 % of Ga, the balance being Cu and unavoidable impurities, wherein the powder has an oxygen content of 200 ppm or less.

2. The Cu-Ga based alloy powder according to claim 1 wherein the Ga content is more than 29% and not more than 38%.

3. The Cu-Ga based alloy powder according to any one of claims 1 to 2, wherein the oxygen content of 150 ppm or less.

4. The Cu-Ga based alloy powder according to any one of claims 1 to 3, which is obtained by gas atomizing method or disc atomizing method.

5. A Cu-Ga based alloy sputtering target material consisting of, in at%, not less than 25% and less than 40 % of Ga, the balance being Cu and unavoidable impurities, wherein the sputtering target has an oxygen content of less than 250 ppm and a crystal particle size of more than 10 µm and not more than 100 µm.

6. The Cu-Ga based alloy sputtering target material according to claim 5, wherein the content of Ga is more than 29% and not more than 38%.

7. The Cu-Ga based alloy sputtering target material according to any one of claims 5 to 6, wherein the oxygen content is 200 ppm or less.

8. A method for producing a Cu-Ga based alloy sputtering target material comprising:
providing, as a raw material, the Cu-Ga based alloy powder according to any one of claims 1 to 4; and
consolidating the raw material at a temperature of 400 to 850 °C.

9. The method according to claim 8, wherein the consolidation temperature is from 650 °C to 830 °C.

## Patentansprüche

1. Cu-Ga-basiertes Legierungspulver, bestehend aus, in Atom-%, nicht weniger als 25% und weniger als 40% Ga, wobei die Differenz Cu und unvermeidbare Verunreinigungen sind, wobei das Pulver einen Sauerstoffgehalt von 200 ppm oder weniger aufweist.

2. Cu-Ga-basiertes Legierungspulver gemäß Anspruch 1, wobei der Ga Gehalt mehr als 29% und nicht mehr als 38% beträgt.

3. Cu-Ga-basiertes Legierungspulver gemäß mindestens einem der Ansprüche 1 bis 2, wobei der Sauerstoffgehalt 150 ppm oder weniger beträgt.

4. Cu-Ga-basiertes Legierungspulver gemäß mindestens einem der Ansprüche 1 bis 3, welches durch ein Gaszerstäubungsverfahren oder Scheibenzerstäubungsverfahren erhalten wurde.

5. Cu-Ga-basiertes Legierungssputterzielmaterial, bestehend aus, in Atom-%, nicht weniger als 25% und weniger als 40% Ga, wobei die Differenz Cu und unvermeidbare Verunreinigungen sind, wobei das Sputterzielmaterial einen Sauerstoffgehalt von weniger als 250 ppm und eine Kristallteilchengröße von mehr als 10 µm und nicht mehr als 100 µm aufweist.

6. Cu-Ga-basiertes Legierungssputterzielmaterial gemäß Anspruch 5, wobei der Ga Gehalt mehr als 29% und nicht mehr als 38% beträgt.

7. Cu-Ga-basiertes Legierungssputterzielmaterial gemäß mindestens einem der Ansprüche 5 bis 6, wobei der Sauerstoffgehalt 200 ppm oder weniger beträgt.

8. Verfahren zur Herstellung eines Cu-Ga-basierten Legierungssputterzielmaterials, umfassend:
das Cu-Ga-basierte Legierungspulver gemäß mindestens einem der Ansprüche 1 bis 4 wird als ein Rohmaterial bereitgestellt; und
das Rohmaterial wird bei einer Temperatur von 400 bis 850 °C verfestigt.

9. Verfahren gemäß Anspruch 8, bei dem die Verfestigungstemperatur 650 °C bis 830 °C beträgt.

## Revendications

1. Poudre d'alliage à base de Cu-Ga constituée de, en % atomique, pas moins de 25% et moins de 40 % de Ga, le reste étant du Cu et des impuretés inévitables, dans laquelle la poudre a une teneur d'oxygène de 200 ppm ou moins.

2. La poudre d'alliage à base de Cu-Ga selon la revendication 1, dans laquelle la teneur de Ga est supérieure à 29% et non supérieure à 38%.

3. La poudre d'alliage à base de Cu-Ga selon l'une quelconque des revendications 1 à 2, dans laquelle la teneur d'oxygène est 150 ppm ou moins.

4. La poudre d'alliage à base de Cu-Ga selon l'une quelconque des revendications 1 à 3, qui est obtenue par un procédé d'atomisation de gaz ou un procédé d'atomisation de disque.

5. Matériau de cible de pulvérisation d'alliage à base de Cu-Ga constituée de, en % atomique, pas moins de 25% et moins de 40 % de Ga, le reste étant du Cu et des impuretés inévitables, dans lequel la cible de pulvérisation a une teneur d'oxygène inférieure à 250 ppm et une taille de particule de cristal supérieure à 10 µm et non supérieure à 100 µm.

6. Le matériau de cible de pulvérisation d'alliage à base de Cu-Ga selon la revendication 5, dans lequel la teneur de Ga est supérieure à 29% et non supérieure à 38%.

7. Le matériau de cible de pulvérisation d'alliage à base de Cu-Ga selon l'une quelconque des revendications 5 à 6, dans lequel la teneur d'oxygène est de 200 ppm ou moins.

8. Procédé de production d'un matériau de cible de pulvérisation d'alliage à base de Cu-Ga comprenant :
la fourniture, en tant que matériau brut, de la poudre d'alliage à base de Cu-Ga selon l'une quelconque des revendications 1 à 4 ; et
la consolidation du matériau brut à une température de 400 à 850 °C.

9. Le procédé selon la revendication 8, dans lequel la température de consolidation est de 650 °C à 830 °C.
